# EUROPEAN PATENT SPECIFICATION

(11) **EP 3 477 622 B1**
(45) Date of publication and mention of the grant of the patent: **28.12.2022**
(21) Application number: 17854726.1
(22) Date of filing: 19.09.2017
(51) Int. Cl.: H01L 51/00, H01L 27/32

(54) **FLEXIBLE, FOLDABLE DISPLAY SCREEN AND PREPARATION METHOD THEREFOR**
FLEXIBLER, FALTBARER ANZEIGESCHIRM UND HERSTELLUNGSVERFAHREN DAFÜR
ÉCRAN D'AFFICHAGE PLIABLE, FLEXIBLE ET SON PROCÉDÉ DE PRÉPARATION

(30) Priority: 29.09.2016 CN 201610864036
(43) Date of publication of application: 01.05.2019
(73) Proprietor: Kunshan New Flat Panel Display Technology Center Co., Ltd., Kunshan, Jiangsu 215300 (CN); Kunshan Go-Visionox Opto-Electronics Co., Ltd., KunShan City, Jiangsu 215300 (CN)
(72) Inventor: DING, Liwei, Jiangsu 215300 (CN); HUANG, Xiuqi, Jiangsu 215300 (CN); ZHU, Hui, Jiangsu 215300 (CN); ZHANG, Xiaobao, Jiangsu 215300 (CN)
(74) Representative: Kraus & Weisert Patentanwälte PartGmbB
(86) International application number: PCT/CN2017/102279
(87) International publication number: WO 2018/059276

(56) References cited:
- CN-A- 103 681 357
- CN-A- 104 752 443
- CN-A- 104 849 928
- CN-A- 105 632 991
- CN-A- 106 205 398
- US-A1- 2008 169 063
- US-A1- 2015 371 612
- US-A1- 2016 254 329

## Description

### TECHNICAL FIELD

The present disclosure relates to a structure and a manufacturing method of a display screen, and more particularly, to a structure and a manufacturing method of a flexible foldable display screen.

### BACKGROUND

Flexible display screens have the advantage of significant flexibility deformation, and may be bent and folded at a large angle, and thus the portability of devices may be effectively improved by using this type of screen. With the maturity of flexible display technologies, the flexible display screens have gradually integrated into mobile devices such as mobile phones and tablets, and become main tools of our lives.

The existed (rigid or semi-rigid) display screens generally include a glass substrate (layer), a flexible screen body (layer) and a controlling IC (layer) combined sequentially. The flexible screen body for displaying images includes pixel units densely arranged on a flexible substrate and signal lines (harnesses) disposed at the periphery of the pixel units and traced at the edge of the flexible screen body. The controlling IC for generating control signals or power signals uses a flexible circuit board (FPC) carrying chip components and a cured packaged integrated circuit module. The glass substrate for supporting and curing the flexible screen body uses an elastic and rigid glass substrate. The existed display screens also include a power circuit, which includes a semi-cured core and a larger size power component.

US 2016/254329 A1 discloses a flexible display panel that includes a display element and a drive unit disposed on a first surface of a flexible base and a supporting substrate disposed on a second surface, opposite to the first surface, of the flexible base. CN 104 849 928 A discloses a thin-film transistor (TFT) array substrate that includes a substrate having at least a display region; and a plurality of top-gated thin-film transistors formed over the substrate. The TFT array substrate also comprises a plurality of scan lines and a plurality of data lines formed over the substrate in the display region and defining a plurality of sub-pixels.

How to separate the flexible screen body from the whole screen individually, how to fully utilize characteristics of the flexible screen body to form good display effect, how to reflect display quality of the flexible screen body, and how to eliminate negative influence of control lines while ensuring the display effect and quality need to be redesigned or technically improved.

### SUMMARY

In view of the above, embodiments of the present invention provide a method for manufacturing a flexible foldable display screen as recited in claim 1, which solves technical problems that display effect becomes worse due to the screen circuit and the driving chip are damaged during bending or peeling process of the flexible screen body.

The embodiments of the present invention further provides a flexible foldable display screen as recited in claim 6, which solves a technical problem that existed mobile devices cannot fully utilize the flexible screen body to improve the display effect.

A method for manufacturing a flexible foldable display screen of the present invention, including: forming a flexible screen body on a glass substrate, wherein the flexible screen body includes a display area and a curing assembling area formed at an end of the flexible screen body; forming a pixel sparse area at an edge of the display area, wherein a pixel unit density of pixel units disposed in the pixel sparse area is smaller than that of pixel units disposed outside the pixel sparse area, and a pitch between adjacent pixel units in the pixel sparse area accommodates to an outer diameter of signal lines; disposing the signal lines evenly between the pixel units in the pixel sparse area; disposing a controlling IC in the curing assembling area; peeling off a part of the glass substrate corresponding to the display area; and forming a touch input region on a part of the glass substrate corresponding to the curing assembling area.

In an embodiment of the present disclosure, the end of the flexible screen body is an edge of the flexible screen body extending along an extension direction of the flexible screen body, or a pair of opposite edges of the flexible screen body extending along the extension direction of the flexible screen body, or a part of the edge of the flexible screen body, or a part of the opposite edges of the flexible screen body.

In an embodiment of the present disclosure, adjacent pixel units in the pixel sparse area form a pixel matrix, the pixel matrix is evenly arranged, and a pitch between adjacent pixel matrices in the pixel sparse area accommodates to the outer diameter of the signal lines.

In an embodiment of the present disclosure, the pixel unit density is gradually decreased from an inner side to an outer side in the pixel sparse area, and the pitch between adjacent pixel units gradually becomes larger corresponding to the outer diameter of the signal lines.

In an embodiment of the present disclosure, the peeling off a part of the glass substrate corresponding to the display area is performed by a laser lift-off technique.

A flexible foldable display screen of the present invention, including a flexible screen body, a pixel sparse area is formed at an edge of the display area, a glass substrate and a controlling IC, wherein a curing assembling area is defined at an end of the flexible screen body, a flexible screen body outside the curing assembling area is used as a display area, the controlling IC is disposed at a top of the curing assembling area, the glass substrate is disposed at a bottom of the curing assembling area, and a touch input region is formed on a part of the glass substrate corresponding to the curing assembling area, wherein a pixel unit density of pixel units disposed in the pixel sparse area is smaller than that of pixel units disposed outside the pixel sparse area, a pitch between adjacent pixel units in the pixel sparse area accommodates to an outer diameter of signal lines, and the signal lines are evenly disposed between the pixel units in the pixel sparse area.

In an embodiment of the present disclosure, adjacent pixel units in the pixel sparse area form a pixel matrix, the pixel matrix is evenly arranged, and a pitch between adjacent pixel matrices in the pixel sparse area accommodates to the outer diameter of the signal lines.

In an embodiment of the present disclosure, the pixel unit density is gradually decreased from an inner side to an outer side in the pixel sparse area, and the pitch between adjacent pixel units gradually becomes larger corresponding to the outer diameter of the signal lines.

In an embodiment of the present disclosure, the end of the flexible screen body is an edge of the flexible screen body extending along an extension direction of the flexible screen body, or a pair of opposite edges of the flexible screen body extending along the extension direction of the flexible screen body, or a part of the edge of the flexible screen body, or a part of the opposite edges of the flexible screen body.

According to the method for manufacturing a flexible foldable display screen of the present disclosure, characteristics of the present flexible screen bodies may be fully utilized and existed display screen products may be fully utilized, to form a flexible display screen that meets the requirement of the market. By concentrating the components which are not easily bent or folded on the curing assembling area of the flexible screen body that does not need to be peeled off, technical problems that display effect becomes worse due to the screen circuit and the driving chip are damaged during bending or peeling process of the flexible screen body are solved.

The flexible foldable display screen of the present disclosure has reliable quality and fully utilizes a flexible platform; a screen formed by the display area may display without borders, and meanwhile, reliable transmission of control signals and power signals may be ensured.

### BRIEF DESCRIPTION OF THE DRAWINGS

Fig. 1 is a front cross-sectional view of a flexible foldable display screen according to an embodiment of the present disclosure.
Fig. 2 is a structure diagram (a plan view) of a pixel unit arrangement of a flexible screen body of a display area in a flexible foldable display screen according to an embodiment of the present disclosure.
Fig. 3 is a structure diagram (a plan view) of a pixel unit arrangement of a flexible screen body of a display area in a flexible foldable display screen according to another embodiment of the present disclosure.
Fig. 4 is a structure diagram (a plan view) of a pixel unit arrangement of a flexible screen body of a display area in a flexible foldable display screen according to another embodiment of the present disclosure.
Fig. 5 is a flowchart of a method for manufacturing a flexible foldable display screen of the present disclosure.

### DETAILED DESCRIPTION

Technical solutions in the embodiments of the present disclosure will be described clearly and completely with reference to the accompanying drawings in the present disclosure. Apparently, the embodiments described herein are merely some but not all the embodiments of the present disclosure.

A method for manufacturing a flexible foldable display screen of the embodiment includes: forming a curing assembling area at an end of a flexible screen body; disposing a controlling IC in the curing assembling area; making a flexible screen body outside the curing assembling area as a display area, peeling off a glass substrate combined with the display area; and adjusting a size of the glass substrate to accommodate the glass substrate with the curing assembling area.

Specifically, a flexible screen body is formed on the glass substrate. The flexible screen body includes a display area and a curing assembling area at an end of the flexible screen body. A controlling IC is disposed in the curing assembling area. A glass substrate combined with the display area is peeled off. It should be noted that the controlling IC could be disposed in the curing assembling area or could be disposed at an upper surface in the curing assembling area, and the present disclosure is not limited thereto.

According to the method for manufacturing a flexible foldable display screen of the embodiment, characteristics of the present flexible screen bodies may be fully utilized and existed display screen products may be fully utilized, to form a flexible display screen that meets the requirement of the market. By concentrating the components which are not easily bent or folded on the curing assembling area of the flexible screen body that does not need to be peeled off, a peeling yield of the flexible screen body peeling from the glass substrate and the controlling IC could be ensured, and the screen circuit and the driving chip would not be damaged.

The end of the above-mentioned flexible screen body may be an edge of the flexible screen body extending along an extension direction of the flexible screen body, or a pair of opposite (two) edges of the flexible screen body extending along the extension direction of the flexible screen body, or a part of the edge of the flexible screen body, or a part of the opposite edges of the flexible screen body, or an interval portion of the edge of the flexible screen body, or an interval portion of the opposite edges of the flexible screen body.

The above-mentioned interval portion refers to two or more portions spaced from each other.

In the method for manufacturing a flexible foldable display screen of the embodiment, a laser lift-off technique is used to peel off the glass substrate combined with the display area.

In the method for manufacturing a flexible foldable display screen of the embodiment, by utilizing collimation characteristics and high energy adjustable characteristics of the laser, it is available to separate the layers from other layers of the display screen accurately and an separated surface is flat.

The method for manufacturing a flexible foldable display screen of the embodiment further includes: forming a touch input region on a glass substrate corresponding to the curing assembling area.

The above-mentioned touch input region could be formed at any position of the glass substrate, for example, the touch input region could be formed between one side of the glass substrate adjacent to the flexible screen body and the display area, or at the other side of the glass substrate away from the flexible screen body, and the present disclosure is not limited thereto.

In the method for manufacturing a flexible foldable display screen of the embodiment, the glass substrate for supporting purpose could be fully utilized, to form a fixed interactive signal input structure or input circuit, and thus a fixed input interface could be obtained without adding extra space structures.

The above-mentioned forming the touch input region includes disposing corresponding circuits and connecting the circuits.

In addition, in the prior art, a monochromatic strip formed by signal line harnesses traced at the edge of the display area further forms a monochrome border (for example, black) at the edge of the flexible screen body, which affects the overall display effect of the flexible screen body. For this defect, the method for manufacturing a flexible foldable display screen of the embodiment further includes: forming a pixel sparse area at an edge of the display area, wherein the pixel unit density of the pixel unit disposed in the pixel sparse area is smaller than that of the pixel unit disposed outside the pixel sparse area, a pitch between adjacent pixel units in the pixel sparse area accommodates to an outer diameter of signal lines; and the signal lines are evenly disposed between the pixel units in the pixel sparse area.

The above-mentioned pixel unit density refers to the number of pixel units disposed in a unit area.

In the method for manufacturing a flexible foldable display screen of the embodiment, by reducing the pixel unit density at the edge of the flexible screen body in the display area, small line trace space for the tracing of a signal line could be divided at the edge of the display area by utilizing the pixel unit. Since the line trace space is orderly distributed, signal lines in wiring harnesses may be distributed as evenly as possible; meanwhile, diffraction and brightness effects generated when the pixel unit emits light may effectively reduce the differential reflection of a single signal line. In this way, a monochrome strip at the edge of the display area is eliminated, and borderless effect is obtained, and thus the overall display effect of the flexible screen body is significantly improved.

The method for manufacturing a flexible foldable display screen of the embodiment further includes: in the pixel sparse area, a pixel matrix is formed by adjacent pixel units; the pixel matrix is evenly arranged; a pitch of adjacent pixel matrices in the pixel sparse area accommodates to an outer diameter of signal lines; and signal lines are evenly arranged between the pixel matrices.

The above-mentioned pixel matrix could be composed of adjacent pixel units to form a triangle, a rectangle, a diamond or other polygonal contour.

In the method for manufacturing a flexible foldable display screen of the embodiment, the pixel unit density may be adjusted locally in the pixel sparse area, to accommodate to the number of the signal lines and the distance of tracing.

The method for manufacturing a flexible foldable display screen of the embodiment further includes: in the pixel sparse area, a pixel unit density is gradually decreased from an inner side (a side toward the middle of the flexible screen body, vertical or non-vertical) to an outer side (a side toward the edge of the flexible screen body, vertical or non-vertical); in the pixel sparse area, the pitch of pixel units gradually becomes larger corresponding to the outer diameter of the signal lines; and the signal lines are evenly disposed between the pixel units in the pixel sparse area.

The pixel unit density outside the pixel sparse area is larger than that in the inner side of the pixel sparse area, and the pixel unit density in the inner side of the pixel sparse area is larger than that in the outer side of the pixel sparse area.

In the method for manufacturing a flexible foldable display screen of the embodiment, a sparse tracing area and a dense tracing area could be formed in the sparse pixel area under the premise of ensuring the display effect, and thus a reasonable tracing of the signal harnesses is ensured. The dense tracing at the extreme edge has the lowest visual effect quality. However, the borders of the monochromatic strips are not formed may be still ensured, and thus a frameless effect is realized.

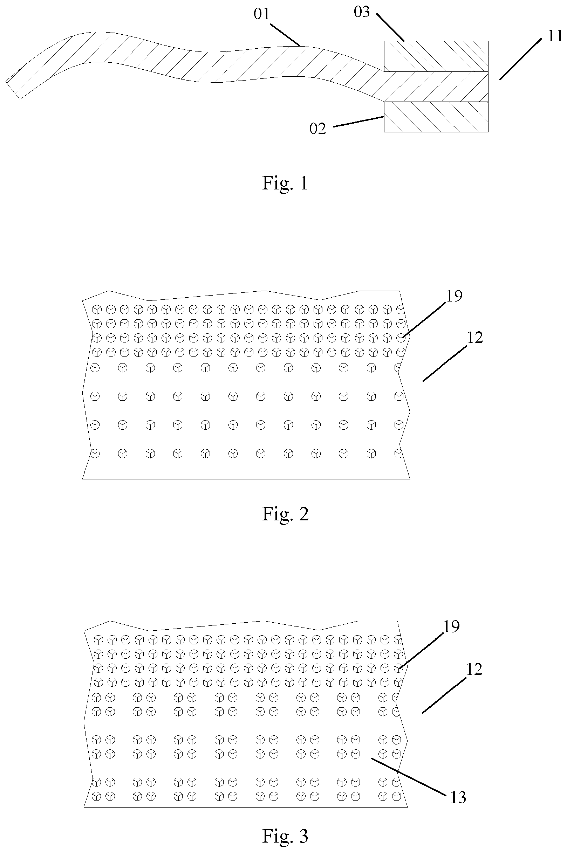

Fig. 1 is a front cross-sectional view of a flexible foldable display screen according to an embodiment. As shown in Fig. 1, the flexible foldable display screen of the embodiment includes a flexible screen body 01, a glass substrate 02 and a controlling IC 03. A curing assembling area 11 is defined at an end of the flexible screen body 01. A flexible screen body outside the curing assembling area 11 is used as a display area. The controlling IC 03 is disposed at the top of the curing assembling area 11, and the glass substrate 02 is disposed at the bottom of the curing assembling area 11.

Fig. 2 is a structure diagram (a plan view) of a pixel unit arrangement of a flexible screen body of a display area in a flexible foldable display screen according to an embodiment. As shown in Fig. 2, according to the flexible foldable display screen of the embodiment, a pixel sparse area 12 is formed at an edge of the flexible screen body 01, and a pixel unit density of a pixel unit 19 disposed in the pixel sparse area 12 is smaller than that of a pixel unit 19 disposed outside the pixel sparse area 12.

A pitch between pixel units 19 in the pixel sparse area 12 accommodates to an outer diameter of a signal line, which is equal to or slightly larger than the outer diameter of the signal line.

Signal lines are evenly disposed between pixel units 19 in the pixel sparse area 12.

Fig. 3 is a structure diagram (a plan view) of a pixel unit arrangement of a flexible screen body of a display area in a flexible foldable display screen according to another embodiment. As shown in Fig. 3, based on the structure of the previous embodiment, in the pixel sparse area 12, a pixel matrix 13 is formed by a plurality of adjacent pixel units 19, and the pixel matrix 13 is evenly arranged.

The pitch between adjacent pixel matrices in the pixel sparse area 12 accommodates to the outer diameter of a signal line.

The signal line is evenly arranged between pixel matrices 13 in the pixel sparse area 12.

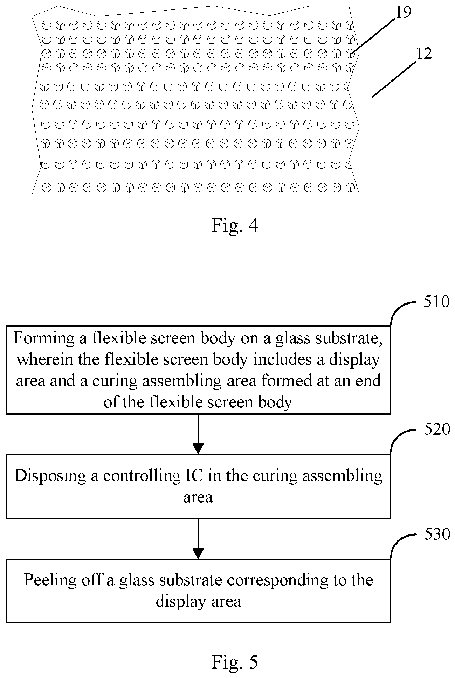

Fig. 4 is a structure diagram (a plan view) of a pixel unit arrangement of a flexible screen body of a display area in a flexible foldable display screen according to another embodiment. As shown in Fig. 4, based on the structure of the previous embodiment, the pixel unit density of the pixel unit 19 is gradually decreased from an inner side to an outer side in the pixel sparse area 12. The pitch between pixel units in the pixel sparse area 12 gradually becomes larger from an inner side to an outer side corresponding to the outer diameter of the signal line.

The signal line is evenly arranged between pixel units in the pixel sparse area.

Fig. 5 is a flowchart of a method for manufacturing a flexible foldable display screen of the present disclosure. As shown in Fig. 5, the method includes following steps.

510: a flexible screen body is formed on a glass substrate, wherein the flexible screen body includes a display area and a curing assembling area formed at an end of the flexible screen body.

520: a controlling IC is disposed in the curing assembling area.

530: a glass substrate corresponding to the display area is peeled off.

In the embodiment of the present disclosure, a size of the glass substrate is adjusted, for example, the glass substrate corresponding to the display area is peeled off, and the residual glass substrate after the peeling process accommodates to the curing assembling area.

The above description is only preferred embodiments of the present disclosure and should not be intended to limit the present disclosure. Those skilled in the art can make various modifications and variations to the present disclosure. The invention is defined by the appended claims.

### INDUSTRIAL APPLICABILITY

In the method for manufacturing a flexible foldable display screen of the present disclosure, by concentrating the components which are not easily bent or folded on the curing assembling area of the flexible screen body that does not need to be peeled off, a peeling yield of the flexible screen body peeling from the glass substrate and the controlling IC could be ensured, and the screen circuit and the driving chip would not be damaged. The flexible foldable display screen of the present disclosure has reliable quality and fully utilizes a flexible platform; a screen formed by the display area may display without borders, and meanwhile, reliable transmission of control signals and power signals may be ensured.

## Claims

1. A method for manufacturing a flexible foldable display screen, comprising
forming (510) a flexible screen body on a glass substrate, the flexible screen body comprising a display area and a curing assembling area formed at an end of the flexible screen body;
forming a pixel sparse area at an edge of the display area, wherein a pixel unit density of pixel units disposed in the pixel sparse area is smaller than that of pixel units disposed outside the pixel sparse area, and a pitch between adjacent pixel units in the pixel sparse area accommodates to an outer diameter of signal lines;
disposing the signal lines evenly between the pixel units in the pixel sparse area;
disposing (520) a controlling IC in the curing assembling area;
peeling (530) off a part of the glass substrate corresponding to the display area; and
forming a touch input region on a part of the glass substrate corresponding to the curing assembling area.

2. The method for manufacturing a flexible foldable display screen of claim 1, wherein the end of the flexible screen body is an edge of the flexible screen body extending along an extension direction of the flexible screen body, or a pair of opposite edges of the flexible screen body extending along the extension direction of the flexible screen body, or a part of the edge of the flexible screen body, or a part of the opposite edges of the flexible screen body.

3. The method for manufacturing a flexible foldable display screen of claim 1, wherein adjacent pixel units in the pixel sparse area form a pixel matrix, the pixel matrix is evenly arranged, and a pitch between adjacent pixel matrices in the pixel sparse area accommodates to the outer diameter of the signal lines.

4. The method for manufacturing a flexible foldable display screen of claim 1, wherein the pixel unit density is gradually decreased from an inner side to an outer side in the pixel sparse area, and the pitch between adjacent pixel units gradually becomes larger corresponding to the outer diameter of the signal lines.

5. The method for manufacturing a flexible foldable display screen of claim 1, wherein the peeling (530) off a part of the glass substrate corresponding to the display area is performed by a laser lift-off technique.

6. A flexible foldable display screen, comprising a flexible screen body (01), a glass substrate (02) and a controlling IC (03), wherein a curing assembling area (11) is defined at an end of the flexible screen body (01), a part of the flexible screen body (01) outside the curing assembling area (11) is used as a display area, the controlling IC (03) is disposed at a top of the curing assembling area (11), the glass substrate (02) is disposed at a bottom of the curing assembling area (11),
**characterised in that**
a touch input region is formed on a part of the glass substrate (02) corresponding to the curing assembling area (11), and
a pixel sparse area (12) is formed at an edge of the display area,
wherein a pixel unit density of pixel units (19) disposed in the pixel sparse area (12) is smaller than that of pixel units (19) disposed outside the pixel sparse area (12), a pitch between adjacent pixel units (19) in the pixel sparse area (12) accommodates to an outer diameter of signal lines, and the signal lines are evenly disposed between the pixel units (19) in the pixel sparse area (12).

7. The flexible foldable display screen of claim 6, wherein adjacent pixel units (19) in the pixel sparse area (12) form a pixel matrix (13), the pixel matrix (13) is evenly arranged, and a pitch between adjacent pixel matrices in the pixel sparse area (12) accommodates to the outer diameter of the signal lines.

8. The flexible foldable display screen of claim 6, wherein the pixel unit density is gradually decreased from an inner side to an outer side in the pixel sparse area (12), and the pitch between adjacent pixel units (19) gradually becomes larger corresponding to the outer diameter of the signal lines.

9. The flexible foldable display screen of claim 6, wherein the end of the flexible screen body (01) is an edge of the flexible screen body (01) extending along an extension direction of the flexible screen body (01), or a pair of opposite edges of the flexible screen body (01) extending along the extension direction of the flexible screen body (01), or a part of the edge of the flexible screen body (01), or a part of the opposite edges of the flexible screen body (01).

## Patentansprüche

1. Verfahren zum Herstellen eines biegsamen faltbaren Anzeigebildschirms, wobei das Verfahren Folgendes umfasst:
Bilden (510) eines biegsamen Bildschirmkörpers auf einem Glassubstrat, wobei der biegsame Bildschirmkörper einen Anzeigebereich und einen Aushärtungsmontagebereich, der an einem Ende des biegsamen Bildschirmkörpers gebildet ist, umfasst;
Bilden eines Bereichs mit spärlichen Pixeln an einem Rand des Anzeigebereichs, wobei eine Pixeleinheitsdichte von Pixeleinheiten, die in dem Bereich mit spärlichen Pixeln angeordnet sind, kleiner ist als die von Pixeleinheiten, die außerhalb des Bereichs mit spärlichen Pixeln angeordnet sind, und wobei ein Abstand zwischen benachbarten Pixeleinheiten in dem Bereich mit spärlichen Pixeln an einen Außendurchmesser von Signalleitungen angepasst ist;
gleichmäßiges Anordnen der Signalleitungen zwischen den Pixeleinheiten in dem Bereich mit spärlichen Pixeln;
Anordnen (520) einer Steuer-IC in dem Aushärtungsmontagebereich;
Ablösen (530) eines Teils des Glassubstrats, der dem Anzeigebereich entspricht;
Bilden eines Berührungseingabegebiets auf einem Teil des Glassubstrats, der dem Aushärtungsmontagebereich entspricht.

2. Verfahren zum Herstellen eines biegsamen faltbaren Anzeigebildschirms nach Anspruch 1, wobei das Ende des biegsamen Bildschirmkörpers ein Rand des biegsamen Bildschirmkörpers, der entlang einer Verlaufsrichtung des biegsamen Bildschirmkörpers verläuft, oder ein Paar gegenüberliegender Ränder des biegsamen Bildschirmkörpers, die entlang der Verlaufsrichtung des biegsamen Bildschirmkörpers verlaufen, oder ein Teil des Rands des biegsamen Bildschirmkörpers oder ein Teil der gegenüberliegenden Ränder des biegsamen Bildschirmkörpers ist.

3. Verfahren zum Herstellen eines biegsamen faltbaren Anzeigebildschirms nach Anspruch 1, wobei benachbarte Pixeleinheiten in dem Bereich mit spärlichen Pixeln eine Pixelmatrix bilden, wobei die Pixelmatrix gleichmäßig angeordnet ist und wobei ein Abstand zwischen benachbarten Pixelmatrizen in dem Bereich mit spärlichen Pixeln an den Außendurchmesser der Signalleitungen angepasst ist.

4. Verfahren zum Herstellen eines biegsamen faltbaren Anzeigebildschirms nach Anspruch 1, wobei die Pixeleinheitsdichte von einer Innenseite zu einer Außenseite in dem Bereich mit spärlichen Pixeln allmählich verringert ist und wobei der Abstand zwischen benachbarten Pixeleinheiten dem Außendurchmesser der Signalleitungen entsprechend allmählich größer wird.

5. Verfahren zum Herstellen eines biegsamen faltbaren Anzeigebildschirms nach Anspruch 1, wobei das Ablösen (530) eines Teils des Glassubstrats, der dem Anzeigebereich entspricht, durch eine Laser-Lift-off-Technik ausgeführt wird.

6. Biegsamer faltbarer Anzeigebildschirm, der einen biegsamen Bildschirmkörper (01), ein Glassubstrat (02) und eine Steuer-IC (03) umfasst, wobei an einem Ende des biegsamen Bildschirmkörpers (01) ein Aushärtungsmontagebereich (11) definiert ist, wobei ein Teil des biegsamen Bildschirmkörpers (01) außerhalb des Aushärtungsmontagebereichs (11) als ein Anzeigebereich verwendet wird, wobei die Steuer-IC (03) auf einer Oberseite des Aushärtungsmontagebereichs (11) angeordnet ist, wobei das Glassubstrat (02) auf einer Unterseite des Aushärtungsmontagebereichs (11) angeordnet ist, **dadurch gekennzeichnet, dass**
auf einem Teil des Glassubstrats (02), der dem Aushärtungsmontagebereich (11) entspricht, ein Berührungseingabegebiet gebildet ist, und
an einem Rand des Anzeigebereichs ein Bereich (12) mit spärlichen Pixeln gebildet ist,
wobei eine Pixeleinheitsdichte von Pixeleinheiten, (19) die in dem Bereich (12) mit spärlichen Pixeln angeordnet sind, kleiner ist als die von Pixeleinheiten (19), die außerhalb des Bereichs (12) mit spärlichen Pixeln angeordnet sind, wobei ein Abstand zwischen benachbarten Pixeleinheiten (19) in dem Bereich (12) mit spärlichen Pixeln an einen Außendurchmesser von Signalleitungen angepasst ist und wobei die Signalleitungen zwischen den Pixeleinheiten (19) in dem Bereich (12) mit spärlichen Pixeln gleichmäßig angeordnet sind.

7. Biegsamer faltbarer Anzeigebildschirm nach Anspruch 6, wobei benachbarte Pixeleinheiten (19) in dem Bereich (12) mit spärlichen Pixeln eine Pixelmatrix (13) bilden, wobei die Pixelmatrix (13) gleichmäßig angeordnet ist und wobei ein Abstand zwischen benachbarten Pixelmatrizen in dem Bereich (12) mit spärlichen Pixeln an den Außendurchmesser der Signalleitungen angepasst ist.

8. Biegsamer faltbarer Anzeigebildschirm nach Anspruch 6, wobei die Pixeleinheitsdichte von einer Innenseite zu einer Außenseite in dem Bereich (12) mit spärlichen Pixeln allmählich verringert ist und wobei der Abstand zwischen benachbarten Pixeleinheiten (19) dem Außendurchmesser der Signalleitungen entsprechend allmählich größer wird.

9. Biegsamer faltbarer Anzeigebildschirm nach Anspruch 6, wobei das Ende des biegsamen Bildschirmkörpers (01) ein Rand des biegsamen Bildschirmkörpers (01), der entlang einer Verlaufsrichtung des biegsamen Bildschirmkörpers (01) verläuft, oder ein Paar gegenüberliegender Ränder des biegsamen Bildschirmkörpers (01), die entlang der Verlaufsrichtung des biegsamen Bildschirmkörpers (01) verlaufen, oder ein Teil des Rands des biegsamen Bildschirmkörpers (01) oder ein Teil der gegenüberliegenden Ränder des biegsamen Bildschirmkörpers (01) ist.

## Revendications

1. Procédé de fabrication d'un écran d'affichage pliable flexible, comprenant les étapes suivantes :
former (510) un corps d'écran flexible sur un substrat de verre, le corps d'écran flexible comprenant une zone d'affichage et une zone d'assemblage de durcissement formée à une extrémité du corps d'écran flexible ;
former une zone à faible densité de pixels sur un bord de la zone d'affichage, où une densité d'unités de pixels des unités de pixels disposées dans la zone à faible densité de pixels est inférieure à celle des unités de pixels disposées à l'extérieur de la zone à faible densité de pixels, et un pas entre des unités de pixels adjacentes dans la zone à faible densité de pixels s'adapte à un diamètre extérieur de lignes de signaux ;
disposer les lignes de signaux de manière régulière entre les unités de pixels dans la zone à faible densité de pixels ;
disposer (520) un circuit intégré de commande dans la zone d'assemblage de durcissement ;
décoller (530) une partie du substrat de verre correspondant à la zone d'affichage ; et
former une région d'entrée tactile sur une partie du substrat de verre correspondant à la zone d'assemblage de durcissement.

2. Procédé de fabrication d'un écran d'affichage pliable flexible selon la revendication 1, dans lequel l'extrémité du corps d'écran flexible est un bord du corps d'écran flexible s'étendant le long d'une direction d'extension du corps d'écran flexible, ou une paire de bords opposés du corps d'écran flexible s'étendant le long de la direction d'extension du corps d'écran flexible, ou une partie du bord du corps d'écran flexible, ou une partie des bords opposés du corps d'écran flexible.

3. Procédé de fabrication d'un écran d'affichage pliable flexible selon la revendication 1, dans lequel des unités de pixels adjacentes dans la zone à faible densité de pixels forment une matrice de pixels, la matrice de pixels est disposée de manière régulière, et un pas entre les matrices de pixels adjacentes dans la zone à faible densité de pixels s'adapte au diamètre extérieur des lignes de signaux.

4. Procédé de fabrication d'un écran d'affichage pliable flexible selon la revendication 1, dans lequel la densité des unités de pixels est progressivement diminuée d'un côté intérieur à un côté extérieur dans la zone à faible densité de pixels, et le pas entre les unités de pixels adjacentes devient progressivement plus grand de manière correspondante au diamètre extérieur des lignes de signaux.

5. Procédé de fabrication d'un écran d'affichage pliable flexible selon la revendication 1, dans lequel le décollage (530) d'une partie du substrat de verre correspondant à la zone d'affichage est effectué par une technique de décollage au laser.

6. Écran d'affichage pliable flexible, comprenant un corps d'écran flexible (01), un substrat en verre (02) et un circuit intégré de commande (03), où une zone d'assemblage de durcissement (11) est définie à une extrémité du corps d'écran flexible (01), une partie du corps d'écran flexible (01) à l'extérieur de la zone d'assemblage de durcissement (11) est utilisée comme zone d'affichage, le circuit intégré de commande (03) est disposé au sommet de la zone d'assemblage de durcissement (11), le substrat en verre (02) est disposé au fond de la zone d'assemblage de durcissement (11),
**caractérisé en ce que** :
une région d'entrée tactile est formée sur une partie du substrat en verre (02) correspondant à la zone d'assemblage de durcissement (11), et
une zone à faible densité de pixels (12) est formée sur un bord de la zone d'affichage,
où une densité d'unités de pixels des unités de pixels (19) disposées dans la zone à faible densité de pixels (12) est inférieure à celle des unités de pixels (19) disposées à l'extérieur de la zone à faible densité de pixels (12), un pas entre des unités de pixels adjacentes (19) dans la zone à faible densité de pixels (12) s'adapte à un diamètre extérieur de lignes de signaux, et les lignes de signaux sont disposées de manière régulière entre les unités de pixels (19) dans la zone à faible densité de pixels (12).

7. Écran d'affichage pliable flexible selon la revendication 6, dans lequel des unités de pixels adjacentes (19) dans la zone à faible densité de pixels (12) forment une matrice de pixels (13), la matrice de pixels (13) est disposée de manière régulière, et un pas entre les matrices de pixels adjacentes dans la zone à faible densité de pixels (12) s'adapte au diamètre extérieur des lignes de signaux.

8. Écran d'affichage pliable flexible selon la revendication 6, dans lequel la densité des unités de pixels est progressivement diminuée d'un côté intérieur à un côté extérieur dans la zone à faible densité de pixels (12), et le pas entre les unités de pixels adjacentes (19) devient progressivement plus grand de manière correspondante au diamètre extérieur des lignes de signaux.

9. Écran d'affichage pliable flexible selon la revendication 6, dans lequel l'extrémité du corps d'écran flexible (01) est un bord du corps d'écran flexible (01) s'étendant le long d'une direction d'extension du corps d'écran flexible (01), ou une paire de bords opposés du corps d'écran flexible (01) s'étendant le long de la direction d'extension du corps d'écran flexible (01), ou une partie du bord du corps d'écran flexible (01), ou une partie des bords opposés du corps d'écran flexible (01).
